(19) Europäisches Patentamt
European Patent Office
Office européen des brevets

(11) **EP 0 791 951 A1**

(12) **EUROPEAN PATENT APPLICATION**

(43) Date of publication:
27.08.1997 Bulletin 1997/35

(51) Int. Cl.⁶: **H01L 21/00**

(21) Application number: **97102786.7**

(22) Date of filing: **20.02.1997**

(84) Designated Contracting States:
**DE FR GB IT NL SE**

(30) Priority: **22.02.1996 JP 34907/96**

(71) Applicant:
**MATSUSHITA ELECTRIC INDUSTRIAL CO., LTD.**
**Kadoma-shi, Osaka 571 (JP)**

(72) Inventors:
• Ogura, Motosugu
 **Takaichi-gun, Nara 6345-01 (JP)**
• Kagawa, Keiichi
 **Hirakata-shi, Osaka 573 (JP)**

(74) Representative: **Grünecker, Kinkeldey,**
 **Stockmair & Schwanhäusser**
 **Anwaltssozietät**
 **Maximilianstrasse 58**
 **80538 München (DE)**

(54) **A semiconductor treating method**

(57) In a semiconductor cleaning step area, a surface of a silicon substrate is cleaned by using pure water substantially containing no carbon dioxide component and no oxygen component in an atmosphere of an inert gas substantially containing no carbon dioxide component and no oxygen component. The surface of the silicon substrate is dried in a semiconductor drying area filled with an inert gas substantially containing no carbon dioxide component, no oxygen component and no water. The silicon substrate having the dried surface is carried to a next step area having a clean tunnel filled with an inert gas substantially containing no carbon dioxide component, no oxygen component and no water through a semiconductor carrying step area filled with an inert gas substantially containing no carbon dioxide component, no oxygen component and no water.

FIG. 1

## Description

BACKGROUND OF THE INVENTION

The present invention relates to a treating method such as cleaning of a semiconductor in the process for manufacturing a semiconductor device having high performance and high reliability.

Usually, ultrapure water is used at a step of cleaning a silicon substrate or a semiconductor thin film formed on the silicon substrate in the process for manufacturing a VLSI on the silicon substrate, in particular. The ultrapure water is very clean water ($H_2O$) which has a high specific resistance of $10^6$ $\Omega$cm or more, does not contain residual impurities that are harmful in the manufacture of the VLSI and has neither particle nor bacteria.

A method for treating a semiconductor comprising a cleaning step to be performed by using the ultrapure water in the process for manufacturing the VLSI will be described below.

For example, a silicon substrate is dip-etched for several tens seconds in an etching solution comprising $NH_4F:HF$ (20:1) to remove a native oxide film formed on the silicon substrate. Then, the etching solution is removed by using the ultrapure water. Thereafter, the surface of the silicon substrate is dried. Subsequently, a next step, for example, a step of forming a gate insulating film, an electrode forming step of evaporating an electrode material, a crystal growing step of forming a semiconductor layer by a vapor phase epitaxy method, or the like is performed.

However, the method for treating a semiconductor according to the prior art has a problem that the native oxide film removed at a dip etching step is formed again at the step of performing cleaning by using the ultrapure water. While the native oxide film formed at the step of performing cleaning by using the ultrapure water has a thickness of about 1 nm, a gate oxide film of a VLSI such as a 1 Gbit DRAM has a thickness of about 5 nm or less. For this reason, the presence of the native oxide film having a thickness of about 1 nm cannot be ignored in respect of device characteristics or in the process for manufacturing a device, and greatly interferes with the formation of an ohmic electrode having excellent reproducibility and a low resistance.

The above-mentioned problem also arises at a step of cleaning a compound semiconductor such as GaAs as well as the step of cleaning a Si substrate.

SUMMARY OF THE INVENTION

In consideration of the foregoing, it is an object of the present invention to prevent formation of a native oxide film at a step of cleaning a semiconductor.

The present inventors investigated the cause of the formation of the native oxide film at a step of performing cleaning by using pure water. As a result, they have found a phenomenon in which a carbon dioxide ($CO_2$) that is contained at an amount of 0.2 % in the air and dissolved in the pure water very well is changed to carbonic acid ($H_2CO_3$) in the pure water to oxidize Si, for example, and have thought of technical ideas that oxidation of Si, that is, the formation of the native oxide film can be prevented by substantially removing a carbon dioxide component from the pure water. The present invention has been made on the basis of the above-mentioned knowledge.

The present invention provides a first method for treating a semiconductor, comprising the step of cleaning a surface of a semiconductor by using pure water substantially containing no carbon dioxide component in an atmosphere of an inert gas substantially containing no carbon dioxide component. The surface of the semiconductor means that of a semiconductor substrate or that of a semiconductor layer formed on the semiconductor substrate.

According to the first method for treating a semiconductor, the surface of the semiconductor is cleaned by using the pure water substantially containing no carbon dioxide component. For this reason, the pure water does not have carbonic acid which is generated by reaction of the carbon dioxide to water. Therefore, it is possible to prevent the semiconductor from being oxidized by hydrogen ions liberated from the carbonic acid. Consequently, a native oxide film is hardly formed on the surface of the semiconductor.

In the first method for treating a semiconductor, preferably, the inert gas substantially contains no oxygen component at the cleaning step and the pure water substantially contains no oxygen component at the cleaning step. Thus, it is possible to prevent the oxidation of the surface of the semiconductor. Consequently, it is much harder that the native oxide film is formed on the surface of the semiconductor.

Preferably, the first method for treating a semiconductor further comprises a step of substituting water remaining on the surface of the semiconductor for an organic solvent containing no carbon dioxide component and no water in an atmosphere of an inert gas substantially containing no carbon dioxide component and no water after the cleaning step. Acetone, trichloroethane, methanol and the like can be used as the organic solvent.

Thus, the pure water remaining on the surface of the semiconductor is removed. In addition, the organic solvent which newly remains on the surface of the semiconductor has no carbonic acid. Therefore, the native oxide film is not formed on the surface of the semiconductor.

In the case where the first method for treating a semiconductor comprises the substituting step, preferably, the inert gas substantially contains no oxygen component at the substituting step and the organic solvent substantially contains no oxygen component at the substituting step. Thus, the oxidation of the surface of the semiconductor can be prevented. Consequently, it is much harder that the native oxide film is formed on the surface of the semiconductor.

In the case where the first method for treating a semiconductor comprises the substituting step, preferably, the first method further comprises a step of drying the semiconductor in an inert gas substantially containing no carbon dioxide component and no water after the substituting step. Thus, the formation of the native oxide film on the surface of the semiconductor can be prevented at the drying step.

In the case where the first method for treating a semiconductor comprises the substituting step, preferably, the first method further comprises a step of carrying the semiconductor to a place where a next step such as an insulating film forming step, an electrode forming step or a crystal growing step is to be performed in an inert gas substantially containing no carbon dioxide component and no water after the substituting step. Thus, the formation of the native oxide film on the surface of the semiconductor can be prevented at the carrying step.

The present invention provides a second method for treating a semiconductor, comprising the step of cleaning a surface of a semiconductor by using an organic solvent substantially containing no carbon dioxide component and no water in an atmosphere of an inert gas substantially containing no carbon dioxide component and no water. The surface of the semiconductor means that of a semiconductor substrate or that of a semiconductor layer formed on the semiconductor substrate. Acetone, trichloroethane, methanol and the like can be used as the organic solvent.

According to the second method for treating a semiconductor, the surface of the semiconductor is cleaned by using the organic solvent substantially containing no carbon dioxide component and no water. For this reason, the organic solvent does not have carbonic acid which is generated by reaction of the carbon dioxide to water. Therefore, it is possible to prevent the semiconductor from being oxidized by hydrogen ions liberated from the carbonic acid. Consequently, a native oxide film is hardly formed on the surface of the semiconductor. In some cases, the surface of a compound semiconductor is etched by using an etching solution containing no water. This treating method is useful for removing such an etching solution by cleaning.

In the second method for treating a semiconductor, preferably, the inert gas substantially contains no oxygen component at the cleaning step and the organic solvent substantially contains no oxygen component at the cleaning step. Thus, it is possible to prevent the oxidation of the surface of the semiconductor. Consequently, it is much harder that the native oxide film is formed on the surface of the semiconductor.

In the first or second method for treating a semiconductor, preferably, the cleaning step includes a step of cleaning the semiconductor while rotating the semiconductor. Thus, in the case where the step of cleaning the semiconductor is performed by a single wafer processing, the efficiency of cleaning the surface of the semiconductor can be enhanced.

Preferably, the first or second method for treating a semiconductor comprises a step of removing an oxide film or a native oxide film formed on at least a portion of the surface of the semiconductor before the cleaning step. Thus, it is possible to prevent the formation of the native oxide film on the surface of the semiconductor from which the oxide film or the native oxide film is removed.

Preferably, the first or second method for treating a semiconductor comprises a step of drying the semiconductor in an inert gas substantially containing no carbon dioxide component and no water after the cleaning step. Thus, it is possible to prevent the formation of the native oxide film on the surface of the semiconductor at the drying step.

In the first or second method for treating a semiconductor, preferably, the inert gas substantially contains no oxygen component at the drying step. Thus, it is possible to prevent the oxidation of the surface of the semiconductor still more at the drying step. Consequently, it is much harder that the native oxide film is formed on the surface of the semiconductor.

Preferably, the first or second method for treating a semiconductor comprises a step of carrying the semiconductor to a place where a next step is to be performed in an inert gas substantially containing no carbon dioxide component and no water after the cleaning step. Thus, it is possible to prevent the formation of the native oxide film on the surface of the semiconductor at the carrying step.

In the first or second method for treating a semiconductor, preferably, the inert gas substantially contains no oxygen component at the carrying step. Thus, it is possible to prevent the oxidation of the surface of the semiconductor still more at the carrying step. Consequently, it is much harder that the native oxide film is formed on the surface of the semiconductor.

According to the first or second method for treating a semiconductor, it is hard that the native oxide film is formed on the surface of the semiconductor. Therefore, a thin film can be formed by a vapor phase epitaxy method, or a gate insulating film and an ohmic electrode can be formed on the surface of the semiconductor on which the native oxide film is hardly formed. Consequently, a crystal growing film of good quality and a gate insulating film having high precision or an ohmic electrode having a low resistance can be obtained. Thus, the characteristics and yield of a semiconductor device can be enhanced greatly.

BRIEF DESCRIPTION OF THE DRAWINGS

The present invention will be detailed in conjunction with the accompanying drawings wherein:

Figure 1 is a schematic view for explaining a method for treating a semiconductor according to a first embodiment of the present invention;

Figure 2 is a schematic view for explaining a method for treating a semiconductor according to a second embodiment of the present invention;

Figures 3 (a) to 3 (e) are sectional views for explaining each step of the method for treating a semiconductor according to the first embodiment of the present invention;

Figures 4 (a) and 4 (b) are sectional views showing an electrode forming step to which the method for treating a semiconductor according to the first embodiment of the present invention is applied;

Figure 5 is a sectional view showing a MOSFET forming step to which the method for treating a semiconductor according to the first embodiment of the present invention is applied; and

Figure 6 is a sectional view showing a MNOS forming step to which the method for treating a semiconductor according to the first embodiment of the present invention is applied.

DETAILED DESCRIPTION OF THE INVENTION

A method for treating a semiconductor according to the present invention will be described below. As a premise, the process in which a carbon dioxide ($CO_2$) is changed to carbonic acid ($H_2CO_3$) in pure water to oxidize Si will be described below.

A very small amount of water ($H_2O$) is ionized as represented by the following formula (a dissociation constant of $1 \times 10^{-7}$). Consequently, equivalent $H^+$ and $OH^-$ are formed. At a temperature of 25°C, about 18 of ten billion water molecules are ionized.

$$H_2O \rightarrow H^+ + OH^-$$

On the other hand, the carbon dioxide ($CO_2$) is dissolved in pure water ($H_2O$) very well. As represented by the following formula, the carbonic acid ($H_2CO_3$) is formed.

$$CO_2 + H_2O \rightarrow H_2CO_3$$

Then, the carbonic acid is dissociated as represented by the following formula (a dissociation constant of $4 \times 10^{-7}$). Consequently, $H^+$ which acts as a base for oxidizing Si is formed.

$$H_2CO_3 \rightarrow H^+ + HCO_3$$

Thereafter, Si is changed to $SiH^+$ by the generated $H^+$ as represented by the following formula.

$$Si + H^+ \rightarrow SiH^+$$

Subsequently, $SiH^+$ reacts to $OH^-$, and then to $H^+$. As a result, $SiO_2$ is formed as shown in the following reaction formula.

$$SiH^+ + 2OH^- + H^+ \rightarrow SiO_2 + 2H_2 \uparrow$$

As is apparent from the above-mentioned investigations, if the surface of the semiconductor is cleaned by using pure water which substantially contains no carbon dioxide component, a native oxide film is not formed on the surface of the semiconductor. It is stated that the native oxide film formed on the surface of the semiconductor at a cleaning step according to the prior art has a thickness of about 1 nm. If the surface of the semiconductor is cleaned by using the pure water which substantially contains no carbon dioxide component, the dissociation constant of $H^+$ is changed from $4 \times 10^{-7}$ to $1 \times 10^{-7}$ or less. Consequently, the thickness of the native oxide film is reduced to less than half as compared with the prior art. When the thickness of the native oxide film can be reduced to less than half, the presence of the native oxide film hardly matters in high-precision control of the thickness of a gate oxide film, the formation of an excellent ohmic electrode and the formation of an excellent crystalline thin film.

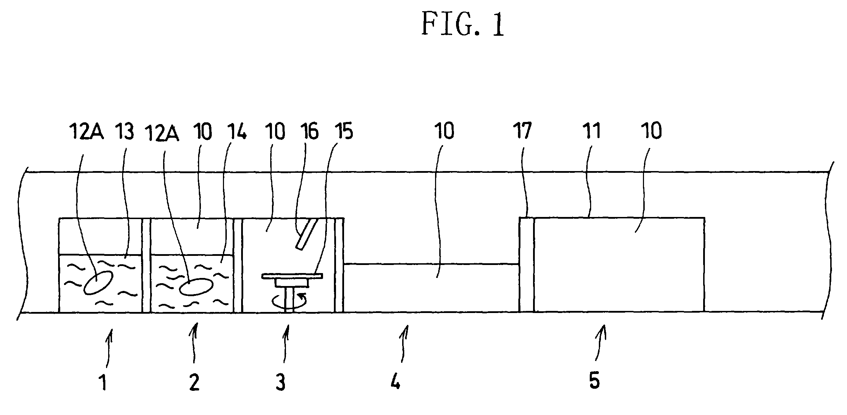

A method for treating a semiconductor according to a first embodiment of the present invention will be described below with reference to Fig. 1. There will be described the case where a compound semiconductor layer such as GaAs or ZnS is formed by a crystal growing method on a Si substrate which is notable as a future substrate for a composite device having new functions.

In Fig. 1, the reference numeral 1 denotes a native oxide film removing step area, the reference numeral 2 denotes a semiconductor cleaning step area, the reference numeral 3 denotes a semiconductor drying step area, the reference numeral 4 denotes a semiconductor carrying step area, and the reference numeral 5 denotes a next step area for performing a vapor phase epitaxy step, an electrode forming step, a gate oxide film forming step or the like.

The semiconductor cleaning step area 2 and the semiconductor drying step area 3 are filled with an inert gas 10 which substantially contains no carbon dioxide component, no oxygen component and no water (while the semiconductor cleaning step area 2 has some evaporated components of pure water and the semiconductor drying step area 3 has a steam component comprising water drops which have remained before drying, the inert gas to be supplied is free from the carbon dioxide component, the oxygen component and the water). The semiconductor carrying step area 4 is filled with the inert gas 10 which is free from a carbon dioxide component, an oxygen component and water. Depending on circumstances, a high vacuum of $1 \times 10^{-5}$ torr or more may be kept. The next step area 5 is covered with a clean tunnel 11 which is filled with the inert gas 10 such as a $N_2$ gas or an argon gas which is free from a carbon dioxide component, an oxygen component and water.

Examples of a method for removing the carbon dioxide component, the oxygen component and the water from the inert gas include a method for performing removal by causing the inert gas to pass through a temperature region of liquid nitrogen (-195.8°C) to liquefy the carbon dioxide component, the oxygen component and the water (a carbon dioxide, oxygen and water have boiling points of -75.8°C, -183.0°C and 100°C, respectively, and the inert gas is usually gaseous at a liquid nitrogen temperature), a method for performing removal by using a catalyst or an adsorbent, a Ti sponge getter method, a Zr getter method and the like. It is supposed that an ordinary inert gas put on the market generally contains hundreds ppb or more of residual components. Therefore, the inert gas put on the market is purified such that the inert gas to be supplied to each step area substantially contains no carbon dioxide component, no oxygen component and no water.

In the present specification, the state in which the carbon dioxide component, the oxygen component or the water is not substantially contained (free) indicates that each content is about 5 ppb or less. As a matter of course, preferably, each content is smaller. If each content is about 1 ppb or less, it is very hard that the native oxide film is formed on the surface of the semiconductor. In each embodiment of the present invention, pure water contains no carbon dioxide component and no oxygen component and an organic solvent and the inert gas contain no carbon dioxide component, no oxygen component and no water. When using the pure water which substantially contains no carbon dioxide component and the organic solvent and the inert gas which substantially contain no carbon dioxide and no water, the object of the present invention can be accomplished. Thus, it is hard that the native oxide film is formed on the surface of the semiconductor.

First of all, the native oxide film removing step will be described below. A silicon substrate 12A is dipped for several tens seconds in an etching solution 13 having $NH_4F:HF = 20:1$ at a room temperature with which the native oxide film removing step area 1 is filled, thereby removing the native oxide film in a predetermined region of the silicon substrate 12A, that is, at least a portion of the surface of the silicon substrate 12A. Steam of the etching solution 13 is always exhausted to the outside of the native oxide film removing step area 1, which is not shown in Fig. 1.

A semiconductor cleaning step will be described below. The silicon substrate 12A from which the native oxide film has been removed is transferred to the semiconductor cleaning step area 2 filled with the inert gas 10 which substantially contains no carbon dioxide component, no oxygen component and no water, and is then cleaned by using ultrapure water 14 which substantially contains no carbon dioxide component and no oxygen component. Thus, the etching solution remaining on the surface of the silicon substrate 12A is fully removed. While cleaning has been performed by using ultrapure water having no bacteria in a purification system for ultrapure water in the prior art, the cleaning is performed by using ultrapure water which has no bacteria and in which neither the carbon dioxide component nor the oxygen component is dissolved as a base for oxidizing the semiconductor in the first embodiment. The semiconductor cleaning step is performed in the state where the ultrapure water containing no carbon dioxide component and no oxygen component continually flows in the semiconductor cleaning step area 2. Such ultrapure water can be obtained by using an ion exchange resin equipment, a ultrafiltration equipment (UF equipment) or a reverse osmosis unit (RO unit) and a storage tank which is filled with the inert gas containing no carbon dioxide component and no oxygen component and is sealed.

A semiconductor drying step will be described below. The silicon substrate 12A cleaned by using the ultrapure water is transferred to the semiconductor drying step area 3 which is filled with the inert gas 10 that substantially contains no carbon dioxide component, no oxygen component and no water, and is mounted on a spinner chuck 15 to perform spin drying.

Before performing the spin drying, the ultrapure water containing no carbon dioxide component and no oxygen component may be sprayed on the surface of the silicon substrate 12A through a pure water jet nozzle 16 to clean (spin cleaning) the silicon substrate 12A again by using fresh ultrapure water.

In place of the spin drying, a dry inert gas containing no carbon dioxide component, no oxygen component and no water may be sprayed on the silicon substrate 12A to be dried instantly.

In the case where the silicon substrate 12A is not dried fully by the spin drying, it may be heated. More specifically, the spin drying may be performed while spraying the heated inert gas on the silicon substrate 12A, the heated inert gas may be sprayed on the silicon substrate 12A after the spin drying, or the temperature of the semiconductor drying area 3 may be kept high.

A semiconductor carrying step will be described below. The dry silicon substrate 12A is caused to pass through the carrying step area 4 under the environment which is filled with the inert gas containing no carbon dioxide component, no oxygen component and no water or the environment having a high vacuum, and is transferred to the next step area 5 via a gate valve 17.

A next step will be described below. Examples of the next step include a crystal growing step, a gate oxide film forming step which requires the control of a film thickness with high precision, an electrode forming step to be performed after the formation of a contact hole and the like. A step of forming a compound semiconductor layer such as GaAs or ZnS by a crystal growing method by means of a vapor phase epitaxy apparatus will be described below. For example, an organic metal vapor phase epitaxy apparatus is used as the vapor phase epitaxy apparatus, and a load lock method is employed. In the case where the compound semiconductor layer such as GaAs or ZnS is caused to crystal-grow on the silicon substrate 12A by the vapor phase epitaxy method, the surface of the substrate, that is, the initial stage of growth is very important to the vapor phase epitaxy method. If the native oxide film is formed on the silicon substrate 12A, it is hard to obtain an excellent epitaxial growing film.

In the prior art, a temperature is raised to 900°C or more in the vapor phase epitaxy apparatus, the silicon substrate is mounted in a $H_2$ gas or a gas for crystal growth is caused to flow (a $H_2S$ gas is used for the compound semiconductor layer comprising ZnS) to remove the native oxide film. Then, the temperature is lowered to perform epitaxial growth at a predetermined growth temperature (350°C for the compound semiconductor layer comprising ZnS, and a temperature corresponding to a two-stage growing method for performing pre-growth before growth if the compound semiconductor layer comprising GaAs is used).

According to the first embodiment, however, it is not necessary to expose the silicon substrate 12A to the high temperature described above. Consequently, the number of steps can be reduced. If the silicon substrate or the compound semiconductor substrate having an integrated circuit formed thereon is exposed to the high temperature, impurities are diffused or the shape of an element is changed. Thus, there is a possibility that the characteristics of the integrated circuit might be deteriorated. According to the first embodiment, the native oxide film is not formed after the cleaning step. For this reason, it is not necessary to expose the semiconductor substrate to the high temperature. Consequently, the above-mentioned problem does not arise.

There is a method for causing an etching gas to flow in the vapor phase epitaxy apparatus in order to remove the native oxide film. However, if the etching gas is caused to flow in a reactor core pipe holding the semiconductor substrate, the whole piping system of the apparatus is corroded. Accordingly, this method is not preferable.

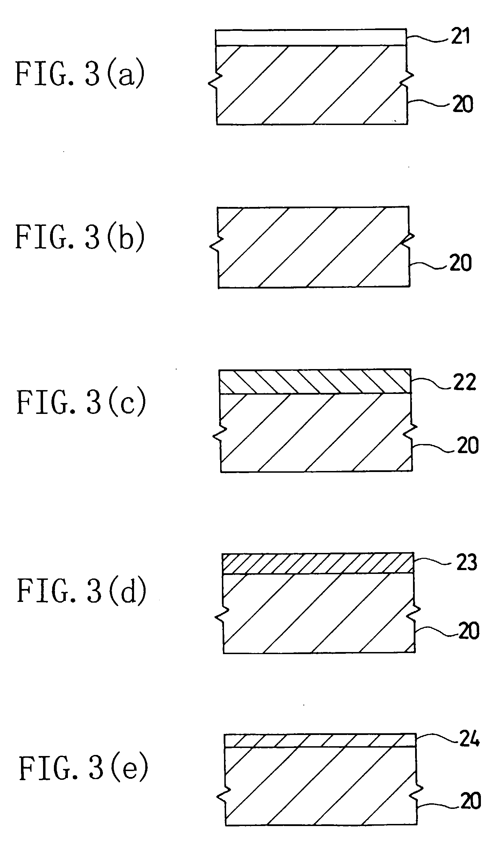

Figs. 3 (a) to 3 (e) show the sectional structure of the silicon substrate on which a series of processes described above are performed.

At the native oxide film removing step, a silicon substrate 20 having a native oxide film 21 formed thereon is dipped in an etching solution as shown in Fig. 3 (a), and the native oxide film 21 is removed as shown in Fig. 3 (b). Then, the etching solution remaining on the surface of the silicon substrate 20 is cleaned by using ultrapure water at the semiconductor cleaning step. Thereafter, the surface of the silicon substrate 20 is dried.

At the next step, a ZnS film 22 is formed on the silicon substrate 20 by the vapor phase epitaxy apparatus as shown in Fig. 3 (c), and an electrode 23 is formed on the silicon substrate 20 by an electrode material forming apparatus (for example, a metal depositing apparatus for evaporating Al, Au and the like, or a polysilicon deposition equipment) as shown in Fig. 3 (d), and a gate oxide film 24 having a thickness of 10 nm or less is formed on the silicon substrate 20 by a thermal oxidation furnace as shown in Fig. 3 (e).

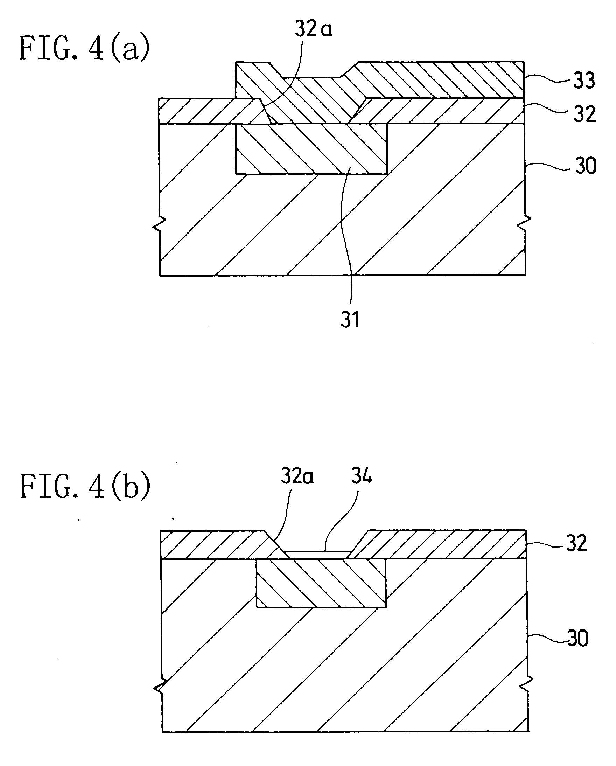

In place of the process for forming the compound semiconductor layer on the silicon substrate by the crystal growing method, the case where the first embodiment is applied to the electrode forming step to be performed after the formation of a contact hole will be described below with reference to Fig. 4.

As shown in Fig. 4 (a), an $n^+$ type diffusion region 31 is formed on a surface portion of a p type silicon substrate 30, and a silicon oxide film 32 is then formed over the whole silicon substrate 30. Thereafter, a resist pattern 33 is formed on the silicon oxide film 32 by photolithography. After a contact hole 32a is formed on the silicon oxide film 32 by using the resist pattern 33, the resist pattern 33 is removed. At this step, a native oxide film 34 is formed in a region exposed to the contact hole 32a in the diffusion region 31 as shown in Fig. 4 (b).

At the native oxide film forming step described above, the native oxide film 34 is removed by using a $NH_4F$:HF based etching solution. Then, the semiconductor cleaning step, the semiconductor drying step and the semiconductor carrying step are performed. At the next step, aluminum is deposited to form an electrode (see Fig. 3 (d)). In the prior art, the native oxide film is formed at the semiconductor cleaning step or the semiconductor drying step. For this reason, when the electrode is formed at the next step, contact failures are sometimes caused. According to the first embodiment, however, the semiconductor cleaning step and the semiconductor drying step are performed in the state where the carbon dioxide component and the oxygen component are free. Consequently, it is very hard that a contact failure is caused.

In general, the $n^+$ type diffusion region 31 is doped at $10^{20}$ to $10^{21}$ $cm^{-3}$. Therefore, the native oxide film 34 is easily formed. For example, when the $NH_4F$:HF based etching solution is cleaned for 5 minutes by using the conventional ultrapure water after performing dip etching, the native oxide film having a thickness of about 4 nm is formed. Consequently, a lot of contact failures are caused in a LSI of an analog-digital converter (hereinafter ADC), for example. On the other hand, when the semiconductor is cleaned for 2 minutes by using the ultrapure water, the contact failures are considerably reduced in the LSI of the ADC. In the prior art, the time for the semiconductor cleaning step has been shortened in order to reduce the contact failures. However, the etching solution is not completely removed. Therefore, long-term reliability has a problem.

If cleaning is performed in the state where the carbon dioxide component and the oxygen component are free in the same manner as in the first embodiment, it is hard that a contact failure is caused by the native oxide film. Consequently, a sufficient cleaning time for 5 minutes or more can be kept. Thus, it is possible to solve, at once, the problem of the contact failures caused by the native oxide film and the problem of chemicals contamination caused by insufficient cleaning.

In a MOSFET having an electrode formed of aluminum, punch through of aluminum is caused by sintering. While in a resistive load MOSFET having an electrode formed of polysilicon, punch through of polysilicon is not caused by sintering. For this reason, even if the native oxide film is slightly formed at the bottom part of the contact hole, current does not flow, with a result of the contact failures. However, by applying the first embodiment, yield can rapidly be enhanced since the contact failures caused by the native oxide film is hard to be caused.

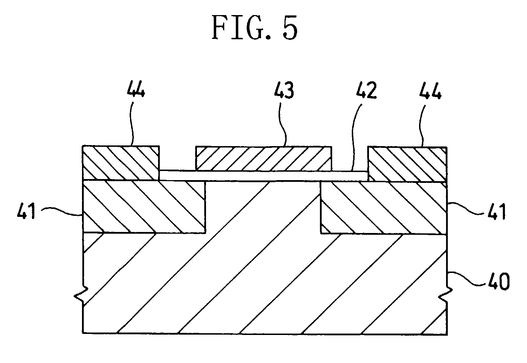

The first embodiment can also be applied to a step of forming an electrode on the back side of a silicon substrate of a semiconductor device such as a semiconductor laser, and a step of forming a thin gate oxide film on the silicon substrate. The case where the first embodiment is applied to the step of forming the gate oxide film on the silicon substrate will be described below with reference to Fig. 5.

Fig. 5 shows the sectional structure of a MOSFET, wherein an $n^+$ conductivity type diffusion region 41 which acts as a source-drain region is formed on a p conductivity type silicon substrate 40, and a gate electrode 43 is formed above the $n^+$ conductivity type diffusion region 41 with a gate oxide film 42 interposed therebetween, and a source-drain electrode 44 is formed in the diffusion region 41. In a DRAM having memories of 1 Gbit or more, the gate oxide film 42 has a thickness of about 5 nm. The gate oxide film 42 is formed by performing a dry oxidizing step for about 30 minutes at a temperature of 800°C, for example. If a native oxide film having a thickness of about 1 nm has already been formed on the silicon substrate 40 before the dry thermal oxidizing process, a set error of about 20 % is made on the thickness of the gate oxide film 42. Consequently, it is hard to control the film thickness so that device characteristics such as $V_T$ (threshold voltage) characteristics have a great variation in some cases. However, the $V_T$ characteristics can be restricted to ±3% or less by applying the first embodiment.

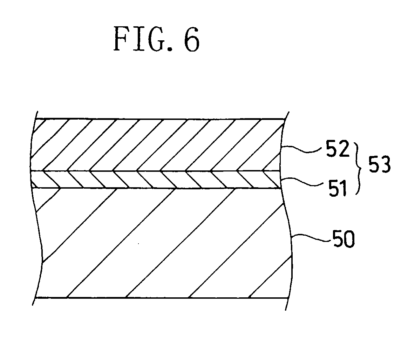

Fig. 6 shows the sectional structure of a MNOS (Metal Nitride Oxide Semiconductor) used for an EPROM and the like. A gate insulating film 53 comprising a thin $SiO_2$ film (thermal oxide film) 51 having a thickness of about 2 nm and a $Si_3N_4$ film 52 is formed on a silicon substrate 50. The $SiO_2$ film 51 is formed at the dry oxidizing step. It is apparent that an excellent MNOS cannot be formed if a native oxide film whose thickness is uncertain is formed on the silicon substrate 50 in advance. By applying the first embodiment, however, it is possible to form the excellent MNOS with high controllability.

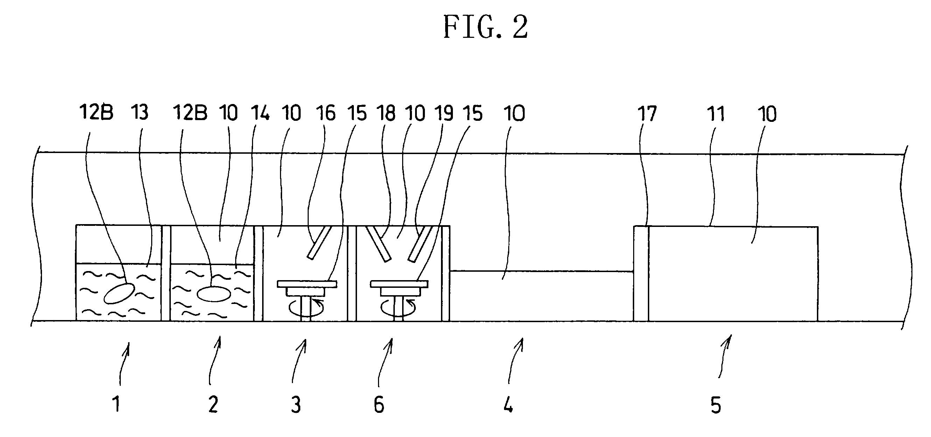

A method for treating a semiconductor according to a second embodiment of the present invention will be described below with reference to Fig. 2. For a silicon substrate, an organic solvent is rarely used when performing cleaning in ordinary processes except for the start of a semiconductor process. However, the organic solvent is often used at a cleaning step in the process of a compound semiconductor such as GaAs or InP. In particular, the form in which a drying step performed after cleaning is terminated by a process using the organic solvent is often employed at a final cleaning step performed before a next step. More specifically, after an etching solution is fully removed by using pure water, water remaining on a semiconductor is substituted for the organic solvent to perform drying. In this case, pure water ($H_2O$) remaining on the surface of the semiconductor is substituted for the organic solvent such as methanol, isopropyl alcohol or acetone. In the second embodiment, a carbon dioxide component, an oxygen component and water are made free to prevent the surface of the semiconductor from being oxidized at a substituting-drying step.

In Fig. 2, the reference numeral 1 denotes a native oxide film removing step area, the reference numeral 2 denotes a semiconductor cleaning step area, the reference numeral 3 denotes a semiconductor drying step area, the reference numeral 6 denotes an organic solvent substituting step area, the reference numeral 4 denotes a semiconductor carrying step area, and the reference numeral 5 denotes a next step area. The organic solvent substituting step area 6 is filled with an inert gas (for example, a $N_2$ gas or an argon gas) 10 which is free from a carbon dioxide component, an oxygen component and water.

At a native oxide film removing step, a semiconductor cleaning step, a semiconductor drying step, a semiconductor carrying step and a next step in the second embodiment, the same processes as in the first embodiment are performed. Therefore, the same reference numerals as in Fig. 1 are attached and their description will be omitted. Only an organic solvent substituting step to be performed in the organic solvent substituting step area 6 will be described below. In Fig. 2, 12B denotes a compound semiconductor substrate.

The compound semiconductor substrate 12B dried in the semiconductor drying step area 2 is mounted on a spinner chuck 15 provided in the organic solvent substituting step area 6. Then, acetone or methanol is supplied onto the rotary compound semiconductor substrate 12B through an acetone supply nozzle 18 or a methanol supply nozzle 19. Thus, the water remaining on the surface of the compound semiconductor substrate 12B is substituted for the organic solvent. The organic solvent substituting process also serves to clean the compound semiconductor substrate 12B by using the organic solvent. When predetermined cleaning, for example, cleaning using methanol is completed, the supply of methanol is stopped to perform spin drying at a high speed so that the drying step using the organic solvent can be continuously performed in the organic solvent substituting step area 6. Thus, it is possible to prevent the formation of the native oxide film on the surface of the compound semiconductor substrate 12B until the cleaning step using ultrapure water, the organic solvent substituting step, and the drying step using the organic solvent are completed.

While the organic solvent substituting step and the drying step using the organic solvent are performed in the organic solvent substituting step area 6 in the second embodiment, only cleaning using the organic solvent may be performed instead. In this case, the ultrapure water according to the first embodiment is substituted for the organic solvent. More specifically, the compound semiconductor 12B dried in the semiconductor drying step area 2 may be cleaned by using the organic solvent in the same area as the semiconductor cleaning step area 2 and the organic solvent may be then dried in the same area as the semiconductor drying step area 3.

While the invention has been described in detail, the foregoing description is in all aspects illustrative and not restrictive. It is understood that numerous other modifications and variations can be devised without departing from the scope of the invention.

**Claims**

1. A method for treating a semiconductor, comprising the step of:

   cleaning a surface of a semiconductor by using pure water substantially containing no carbon dioxide component in an atmosphere of an inert gas substantially containing no carbon dioxide component.

2. The method for treating a semiconductor as defined in Claim 1, wherein the inert gas substantially contains no oxygen component at the cleaning step and the pure water substantially contains no oxygen component at the cleaning step.

3. The method for treating a semiconductor as defined in Claim 1, further comprising a step of substituting water remaining on the surface of the semiconductor for an organic solvent containing no carbon dioxide component and no water in an atmosphere of an inert gas substantially containing no carbon dioxide component and no water after the cleaning step.

4. The method for treating a semiconductor as defined in Claim 3, wherein the inert gas substantially contains no oxygen component at the substituting step and the organic solvent substantially contains no oxygen component at the substituting step.

5. The method for treating a semiconductor as defined in Claim 3, further comprising a step of drying the semiconductor in the inert gas substantially containing no carbon dioxide component and no water after the substituting step.

6. The method for treating a semiconductor as defined in Claim 3, further comprising a step of carrying the semiconductor to a place where a next step such as an insulating film forming step, an electrode forming step or a crystal growing step is to be performed in the inert gas substantially containing no carbon dioxide component and no water after the substituting step.

7. The method for treating a semiconductor as defined in Claim 1, wherein the cleaning step includes a step of cleaning the semiconductor while rotating the semiconductor.

8. The method for treating a semiconductor as defined in Claim 1, further comprising a step of removing an oxide film or a native oxide film formed on at least a portion of the surface of the semiconductor before the cleaning step.

9. The method for treating a semiconductor as defined in Claim 1, further comprising a step of drying the semiconductor in an inert gas substantially containing no carbon dioxide component and no water after the cleaning step.

10. The method for treating a semiconductor as defined in Claim 9, wherein the inert gas substantially contains no oxygen component at the drying step.

11. The method for treating a semiconductor as defined in Claim 1, further comprising a step of carrying the semiconductor to a place where a next step such as an insulating film forming step, an electrode forming step or a crystal growing step is to be performed in an inert gas substantially containing no carbon dioxide component and no water after the cleaning step.

12. The method for treating a semiconductor as defined in Claim 11, wherein the inert gas substantially contains no oxygen component at the carrying step.

13. A method for treating a semiconductor, comprising the step of:

   cleaning a surface of a semiconductor by using an organic solvent substantially containing no carbon dioxide component and no water in an atmosphere of an inert gas substantially containing no carbon dioxide component and no water.

14. The method for treating a semiconductor as defined in Claim 13, wherein the inert gas substantially contains no oxygen component at the cleaning step and the organic solvent substantially contains no oxygen component at the cleaning step.

15. The method for treating a semiconductor as defined in Claim 13, wherein the cleaning step includes a step of cleaning the semiconductor while rotating the semiconductor.

16. The method for treating a semiconductor as defined in Claim 13, further comprising a step of removing an oxide film or a native oxide film formed on at least a portion of the surface of the semiconductor before the cleaning step.

17. The method for treating a semiconductor as defined in Claim 13, further comprising a step of drying the semiconductor in an inert gas substantially containing no carbon dioxide component and no water after the cleaning step.

18. The method for treating a semiconductor as defined in Claim 17, wherein the inert gas substantially contains no oxygen component at the drying step.

19. The method for treating a semiconductor as defined in Claim 13, further comprising a step of carrying the semiconductor to a place where a next step such as an insulating film forming step, an electrode forming step or a crystal growing step is to be performed in an inert gas substantially containing no carbon dioxide component and no water after the cleaning step.

20. The method for treating a semiconductor as defined in Claim 19, wherein the inert gas substantially contains no oxygen component at the carrying step.

FIG. 1

FIG. 2

FIG. 3(a)

FIG. 3(b)

FIG. 3(c)

FIG. 3(d)

FIG. 3(e)

FIG. 4(a)

32a

33

32

30

31

FIG. 4(b)

32a  34

32

30

# FIG. 5

FIG. 6

European Patent
Office

**EUROPEAN SEARCH REPORT**

Application Number

EP 97 10 2786

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 092 937 A (OGURA ET AL.)<br>* column 1, line 61 - column 2, line 24 *<br>* column 4, line 50 - column 7, line 7; figure 1 *<br>--- | 1-12 | H01L21/00 |
| X | GB 2 178 594 A (CHRISTOPHER FRANK MCCONNELL)<br>* page 2, line 81 - page 2, line 99 *<br>--- | 1 | |
| A | PATENT ABSTRACTS OF JAPAN<br>vol. 14, no. 184 (C-0709), 13 April 1990<br>& JP 02 030609 A (MITSUI TOATSU CHEM INC), 1 February 1990,<br>* abstract *<br>----- | 1 | |
| | | | TECHNICAL FIELDS SEARCHED (Int.Cl.6) |
| | | | H01L<br>B08B |

The present search report has been drawn up for all claims

| Place of search | Date of completion of the search | Examiner |
|---|---|---|
| THE HAGUE | 11 June 1997 | Bolder, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)